Europäisches Patentamt

(19) European Patent Office

Office européen des brevets

(11) Publication number: **0 034 653**
**B1**

(12) **EUROPEAN PATENT SPECIFICATION**

(45) Date of publication of patent specification: **16.05.84**

(21) Application number: **80106475.9**

(22) Date of filing: **23.10.80**

(51) Int. Cl.³: **H 01 L 45/00,** H 01 L 29/60, G 11 C 11/34

(54) **Dual electron injector structures.**

(30) Priority: **25.02.80 US 124003**

(43) Date of publication of application:
**02.09.81 Bulletin 81/35**

(45) Publication of the grant of the patent:
**16.05.84 Bulletin 84/20**

(84) Designated Contracting States:
**DE FR GB**

(56) References cited:
FR-A-2 256 540
US-A-3 836 992
US-A-4 104 675

APPLIED PHYSICS LETTERS, vol. 31, no. 7,
October 1977, New York, USA H.S. LEE: "A new
approach for the floating-gate MOS
nonvolatile memory" pages 475-476

(73) Proprietor: **International Business Machines Corporation**
**Old Orchard Road**
**Armonk, N.Y. 10504 (US)**

(72) Inventor: **Di Maria, Donelli Joseph**
**Apt. 2A 77 Carpenter Avenue**
**Mt. Kisco, New York 10549 (US)**

(74) Representative: **Ekström, Gösta E.**
**IBM Svenska AB Box 962**
**S-181 09 Lidingö (SE)**

(56) References cited:
JOURNAL OF APPLIED PHYSICS, vol. 50, no. 9,
September 1979, New York, USA D.J.
DIMARIA: "Graded or stepped energy band-
gap-insulator MIS structures (GI-MIS or SI-
MIS)" pages 5826-5829
APPLIED PHYSICS LETTERS, vol. 37, no. 1, July
1980, New York, USA D.J. DIMARIA et al. "Dual
electron injector structure", pages 61-64

Courier Press, Leamington Spa, England.

## Description

This invention relates to improved dual electron injector structures. More specifically the invention is directed to a non-volatile memory device in which the dual injectors are vertically positioned in a stack relative to control and floating gates.

Recently there has been demonstrated semiconductor structures having Si rich $SiO_2$ and Si rich $Si_3N_3$ layers deposited on top of an $SiO_2$ insulator. The Si rich layers serves to give large electron current injection into the $SiO_2$ layer at moderate electric fields. These structures have been found feasible for use in non-volatile semiconductor memory devices.

U.S. Patent No. 4,104,675 assigned to a common assignee discloses a device which uses a graded band gap structure, a region having a graded concentration of Si therein, to make a charge storage device wherein injection of holes or electrons from one contact is possible without simultaneous injection of electrons or holes from the other contact. The patent shows a structure employing the band gap reduction in an GOMOS FET which performs a memory function. The GOMOS structure employs hole trapping near the Si—$SiO_2$ interface with the structure in an FET configuration. The "write" step involves hole injection from the gate electrode under moderate positive voltage bias and transport to the Si—$SiO_2$ interface where some of the positively-charged holes are trapped in a very stable manner. The "erase" step involves electron injection from the gate electrode under moderate negative voltage bias and transport to the Si—$SiO_2$ interface where the electrons would annihilate trapped holes very readily. The "read" operation uses the conductance of the silicon surface to sense the charge state of the oxide region near the Si—$SiO_2$ interface and uses low gate voltages to prevent further charging of this region.

The graded or stepped concentration structure may be fabricated by forming several pyrolytic or chemical vapor deposition (CVD) $SiO_2$ layers over a relatively thick thermal $SiO_2$ layer with the pyrolytic $SiO_2$ layers having sequentially increasing excess Si content. For stepped structures only one or more layers of constant Si concentrations are used. The structure may also be fabricated by controlled Si ion implantation in the thermal $SiO_2$ layer. The structure can also be fabricated using plasma deposited layers of $SiO_2$ graded with Si. Other insulating layers which give enhanced carrier injection from the gate electrode due to actual band gap reduction or effective band gap reduction (for instance, by trap-assisted tunneling) are also possible.

The devices having the structure shown in U.S. Patent 4,104,675 have the limitations of having the charge trapping region being process dependent, suffer from surface state build-up at the Si—$SiO_2$ interface due to the passage of holes, are sensitive to "hot" carrier injection from the Si substrate due to the presence of the trapped holes, and require hole injection and trapping to be the first operation since these traps do not capture electrons without the presence of the holes first.

In U.S. Patent No. 4,217,601 assigned to a common assignee, there is shown an improved graded or stepped silicon concentration structure for making a charge storage device wherein injection of holes or electrons from one contact is possible without compensating injection of electrons or holes from the other contact. The improvement is the inclusion of a charge trapping layer in the thick insulator region adjacent to the silicon semiconducting body. The trapping layer is situated at a distance of approximately 0,005 microns or more from the Si-insulator interface to prevent trapped carriers from tunneling from this layer to the Si substrate.

This trapping layer captures and stores either electrons (write operation) or holes (erase operation) with as close to 100% efficiency as possible. Novel electrically alterable-read-only memory (EAROM) devices using the invention in metal-insulator-semiconductor structures are further described.

The structure is fabricated by forming several pyrolytic or CVD $SiO_2$ layers over a relatively thick thermal $SiO_2$ with the pyrolytic $SiO_2$ layers having sequentially increasing excess Si content. The trapping layer is formed by controlled impurity ion-implantation by diffusion of the impurity into the relatively thick thermal $SiO_2$ layer, or by deposition of the impurity on thermal $SiO_2$ with stoichiometric CVD $SiO_2$ isolating it from the injector region consisting of the Si rich CVD $SiO_2$ layers.

These structures have the limitation of being only a good single carrier electron injector since few holes are injected for the opposite polarity. Consequently, when used in memory devices "erase" times are long (minutes) as compared to write times (milliseconds). See for example the publications to D. J. DiMaria, entitled "Graded or Stepped Energy Band-Gap Insulator MIS Structures (GI—MIS or SI—MIS)" J. Appl. Phys., *50*, 5826 (1979) and to D. J. Di Maria et al., entitled "High Current Injection into $SiO_2$ From Si Rich $SiO_2$ Films and Experimental Applications", to be published May 1980), J. Appl. Phys.

Other dual injector floating gate memory devices are known in the art, e.g., U.S. Patent Nos. 4,037,242, 4,035,820 and 4,142,251 all show such devices. All of these devices, however, show horizontal arrangements of the injectors and floating gates. They are based on the need for two p-n junctions in the silicon substrate and the creation of an avalanche thereacross to effect the write or erase operations. During avalanche, a small fraction of the hot carriers surmount the substrate Si—$SiO_2$ inter-

facial energy barrier, move into the $SiO_2$ layer, and subsequently move to and are trapped on the floating gate under the influence of the appropriate gate bias. Because of the high probability of the hole trapping in the $SiO_2$ layer near the Si—$SiO_2$ interface, this device is not expected to cycle many times because of the field reduction due to this trapped charge which will limit the erase operation of the hole injector. Further disadvantages result from the horizontal arrangement which limits design flexibility, and the high power requirements involved for write and erase operations because of the large Si currents during avalanche.

The invention as claimed is intended to remedy the above mentioned drawbacks. The present invention is an improvement of the above described prior art single injector structures. The improvement is the addition of a vertically positioned second injector proximate to a trapping layer or floating gate structure in the insulator layer. The dual injector structure so provided can now effectively inject holes at the opposite polarity as easily as the injection of electrons by actually ejecting the trapped electrons using the added bottom injector with these being collected by the top gate contact. Thus, when used in a memory device it will provide erase times equivalent to the write times obtained in the single injector memory device. An example of a structure employing the dual injector is an MGOS FET to perform a memory function. More specifically, the MGOS structure employs a charge trapping layer or floating gate near the Si—$SiO_2$ interface of the gate structure in a FET configuration. In the memory contemplated by the present invention there is provided layers of Si rich $SiO_2$—$SiO_2$—Si rich $SiO_2$ situated between the control gate and trapping layer or floating gate of the device. This insulator stack will hereinafter be referred to as a dual electron injector structure (DEIS). Writing or erasing is performed by applying a negative or positive voltage, respectively, to the control gate which injects electrons from the top or bottom injector to the floating gate or back to the control gate.

The invention, which is defined in the attached claims, is described in detail below with reference to the drawings, in which:

FIG. 1 is a schematic representation of a non-volatile n-channel FET memory device using the dual electron injector of this device (not drawn to scale).

FIG. 2 depicts the magnitude of dark current as a function of the magnitude of the gate voltage for a single electron injector on top of the $SiO_2$ layer.

FIG. 3 depicts the magnitude of dark current as a function of the magnitude of the gate voltage for a single electron injector under the $SiO_2$.

FIG. 4 depicts the magnitude of dark current as a function of the magnitude of the gate voltage for a dual electron injector which is essentially the sum of FIGS. 2 and 3.

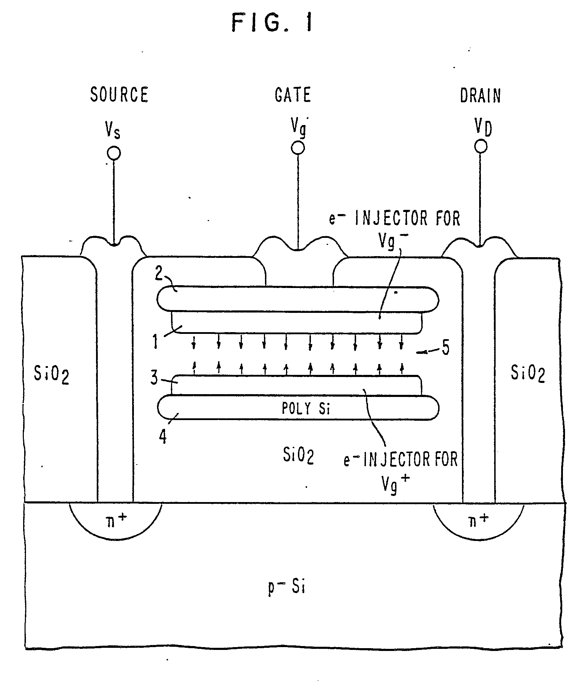

Referring now to FIG. 1 the dual electron injector of the non-volatile n-channel FET memory device is composed of a Si rich $SiO_2$ region 1 which is contiguous with and beneath a polysilicon or metal gate region 2, a second Si rich $SiO_2$ region 3 is contiguous with and atop a floating gate region 4. Regions 1 and 3 are separated by $SiO_2$ area 5. The Si rich $SiO_2$ regions 1 and 3 are prepared by the chemical vapor deposition of $SiO_2$ layers having varying concentrations of Si. Si rich $SiO_2$ layers have graded or stepped concentrations of Si. The number of layers, the thickness of each layer, and the concentration of excess Si in each successive layer is a matter of design choice. Increasing the Si content of the Si rich $SiO_2$ regions enhances the electron injection capability, thereby decreasing write and/or erase voltages and/or times. Of course, one skilled in the art will know that by increasing the Si content to 100% will not provide any enhanced injection. A preferred excess Si content is from about 46% to about 60% atomic Si. The operation of the injectors is not very sensitive to injector thickness (from 0,01 to 0,1 microns) or the exact Si content to within a few percent because the interface of the low resistance Si rich $SiO_2$ layer with the high resistance $SiO_2$ controls the electron injection phenomena. Write and/or erase times can be increased in certain applications, if necessary, by decreasing the Si content of the Si rich $SiO_2$.

In a preferred embodiment the device is fabricated as follows:

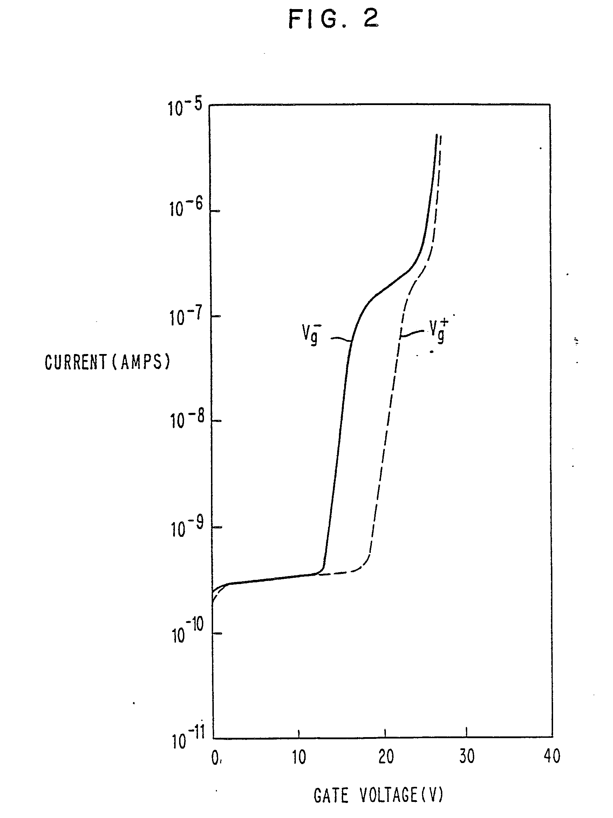

A DEIS stack can be formed, using thermal chemical vapor deposition (CVD) at 700°C or plasma enhanced CVD (PECVD) at a lower temperature of 300—400°C, by depositing layers of Si rich $SiO_2$, $SiO_2$, and Si rich $SiO_2$ on top of single crystal Si, polycrystalline Si, and metal surfaces. For the CVD structures in FIGS. 2—4, the ratio, $R_0$, of the concentration of $N_2O$ to $SiH_4$ in the gas phase for the Si rich $SiO_2$ injectors was 3 corresponding to 13% excess atomic Si over stoichiometric $SiO_2$. For the CVD $SiO_2$ layer, $R_0$ was equal to 100. With $R_0 = 10$, Si rich $SiO_2$ injectors with 7% excess Si and a decreased injection efficiency could be fabricated. Annealing the DEIS structures at 1000°C for 30 minutes in $N_2$, does not affect the injector efficiency, but does remove the charge trapping ledges observed in FIGS. 2—4.

The FET DEIS structure in FIG. 1 is placed in the write or erase modes by using moderate gate voltages between —10V and —30V or +10V and +30V respectively on the control gate electrode, the exact voltage magnitude depending on device configuration. In device cells where capacitive coupling optimization is used, positive voltages in this range are applied to either the drain or gate electrodes, with the control gate at a lower or (higher) potential than the floating gate for write or (erase) operation. Once the floating gate is charged positively or negatively, the device can be read with 0 or +5V on the control gate and a small voltage applied between the source and drain. If the structure is in the erased or written state, either current or no current will flow, respectively, in the FET channel between the source and drain. This structure has excellent charge retention either grounded or floating (at least 100 years at 80°C), and thus serves as a non-volatile memory. It can be cycled approximately $10^5$ to $10^6$ times with the threshold voltage window collapse caused by trapped charge buildup in the CVD $SiO_2$ layer.

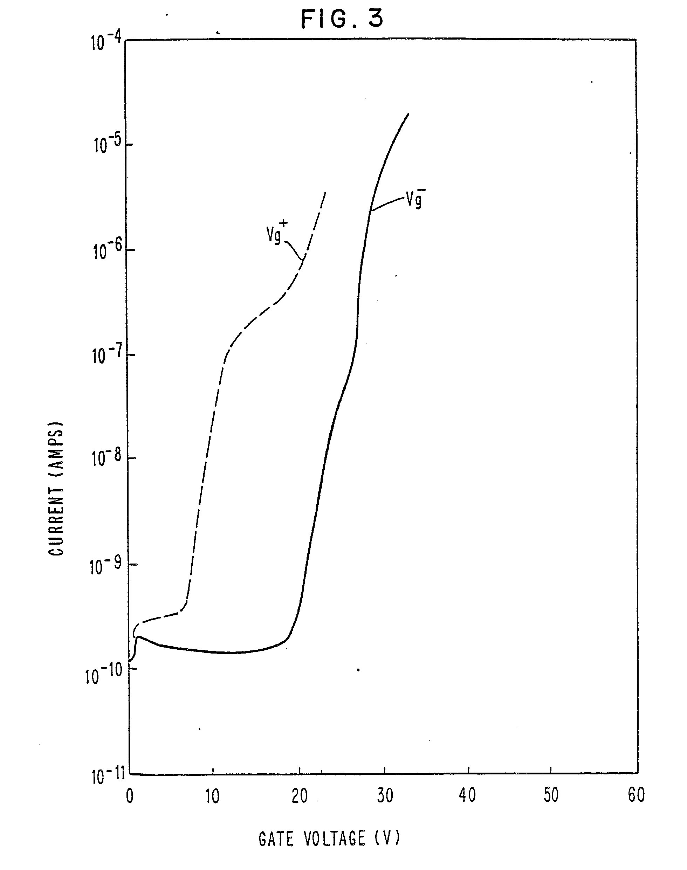

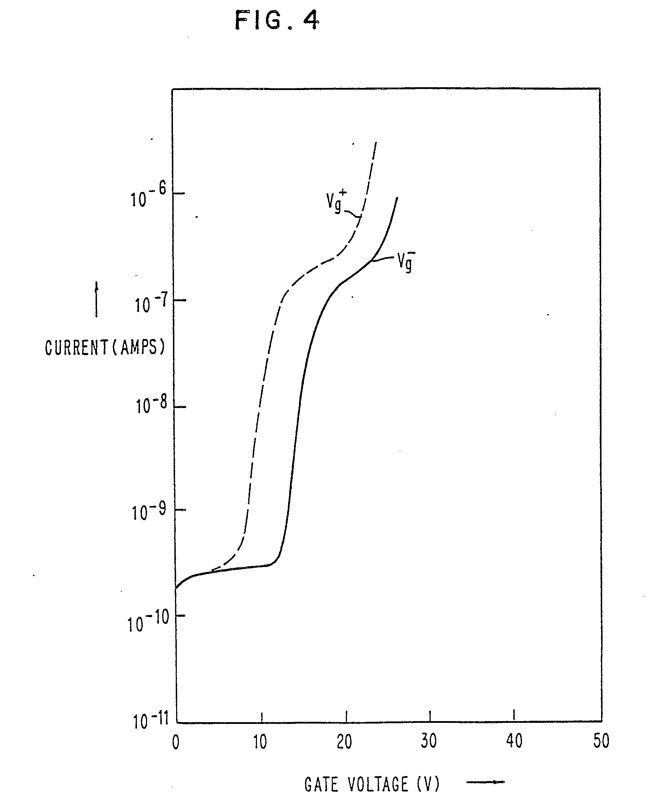

The data of FIGS. 2—4 demonstrate the dual electron injector concept. FIG. 2 and FIG. 3 show a single injector (0,01 microns thick, $R_0 = 3$ rich $SiO_2$ material) in between the Al gate electrode and the $SiO_2$ layer (0,03 microns thick), and Si substrate and $SiO_2$ layer, respectively. Comparing FIGS. 2 and 3, enhanced electron injection is seen from the electrode with the single injector next to it when this electrode is biased at a lower potential than the opposite electrode. The smaller electron currents in FIGS. 2 and 3 are due to Fowler-Nordheim tunneling through about 3 eV interfacial energy barriers at the Si and Al interface with the $SiO_2$ layer. The larger current in each of these figures is thought to be due to field-enhanced Fowler-Nordheim tunneling at the Si rich $SiO_2$—$SiO_2$ interface due to the two phase (Si and $SiO_2$) nature of the Si rich $SiO_2$ material. Because of the high conductivity of the Si rich $SiO_2$ compared to $SiO_2$, only a small fraction of the total applied voltage is dropped across this layer. FIG. 4 shows the total DEIS stack with a CVD injector near each interface (0,01 microns thick, $R_0 = 3$ Si rich $SiO_2$ material) separated by the CVD $SiO_2$ (0,03 microns thick) layer. The measured currents in FIG. 4 are approximately equal to the appropriate enhanced currents due to the Si rich $SiO_2$ injector in FIGS. 2 and 3 for negative Al gate voltage bias (FIG. 2) and positive Al gate voltage bias (FIG. 3). There are two current ledges in the data of FIGS. 2—4. The low current ledge at about $3 \times 10^{10}$ A is due to a displacement current term which is equivalent to the total insulator stack capacitance multiplied by the voltage ramp rate. The current ledge at about $10^{-7}$ A is due to trapping occurring in the CVD $SiO_2$ layer. This trapping ledge which is believed to be due to the presence of $H_2O$ in the films is removed with high temperature annealing (1000°C for 30 min. in $N_2$ or forming gas) prior to gate metallization. From the approximate equivalent position and width of these ledges for either polarity for the DEIS of FIG. 4, the centroid is deduced to be approximately half way into the CVD $SiO_2$ layer. The reduction in ledge width in the ramp I—V data for positive polarity in FIG. 2 and negative polarity in FIG. 3 where current enhancement is absent (no injector present) is thought to be due to field ionization of the trapped electrons and/or reduction in the trapping rate.

The voltage reduction factor for electron injection from the Si substrate side was smaller than the voltage reduction factor for electron injection from the Al side. The voltage reduction factor, defined as the ratio of the gate voltage with a Si rich $SiO_2$ injector present to that without the injector required to obtain a given current, was approximately 1/2 and 2/3 for electron injection from the Si and Al sides, respectively. Although presumably equivalent Si rich $SiO_2$ injectors were deposited (0,01 microns thickness using $R_0 = 3$ material), the $SiO_2$—Si rich $SiO_2$ interfaces for the DEIS structure in FIG. 4 could be different since for the Si side the $SiO_2$ is deposited on the injector and for the Al side the injector is deposited on the $SiO_2$.

The electron injection characteristic of either injector in FIG. 4 could be changed by modifying the Si content of the Si rich $SiO_2$ layers. Injectors with less excess Si have smaller current enhancements (voltage reduction factors closer to 1) and more of the applied voltage is dropped across their layers. Modifying one injector of a DEIS so that more voltage is dropped across it will change the I—V characteristic of the other injector somewhat. Since this unmodified injector and the intervening oxide see a smaller fraction of the total applied voltage bias, the I—V characteristic for this injector will have a particle current threshold above the displacement current level at a larger magnitude of the applied bias, and the I—V characteristic will have a shallower slope. Although Si rich $SiO_2$ injectors in a DEIS configuration have been described here, other injectors such as Si rich $Si_3N_4$ regions are also prepared as above. Also any material which gives high current injection into $SiO_2$ at low to moderate voltages when it is placed between a contacting metal or Si layer and the $SiO_2$ layer can serve as an injector in a DEIS.

## Claims

1. A metal-insulator-semiconductor (MIS) structure comprising a silicon substrate having disposed thereon an insulator layer and bias means on top of said insulator layer for injection of electrons, characterized in that said insulator layer has spaced apart therein at least two silicon rich regions (1 and 3) vertically disposed relative to each other, wherein the upper most disposed silicon rich region (1) is caused to inject electrons when a negative voltage bias of —10 to —30 volts is applied to said bias means (2) and wherein the lower most silicon rich region (3) inject electrons when a positive voltage bias of +10 to 30 volts is applied to said bias means (2), whereby write-erase cycles of about $10^5$ cycles can be obtained without structure breakdown and wherein said erase cycles, will occur at times equivalent to said write cycle.

2. The structure as claimed in claim 1, characterized by a silicon substrate having thereon a silicon dioxide insulator layer and an electrical contact (2) on the silicon dioxide insulator layer, said silicon dioxide insulator layer having vertically disposed therein regions (1 and 3) of graded or stepped compositions near its opposing surfaces.

3. The structure as claimed in claim 1, characterized in that said insulator layer is composed of silicon dioxide containing increasing or constant excess silicon content.

4. The structure as claimed in claim 1, characterized by a silicon substrate having thereon a silicon nitride insulator layer and an electrical contact on the silicon nitride layer, said silicon nitride layer having vertically disposed therein, at least 2 Si rich regions (1 and 3).

5. The structure as claimed in claim 1, characterized in that said insulator layer is composed of silicon nitride containing increasing or constant excess silicon content.

6. A graded oxide metal-silicondioxide-silicon (MGOS)FET structure or a stepped concentration oxide metal-silicon dioxide-silicon structure comprising a silicon substrate having disposed thereon an insulator layer and a gate electrode on top of said insulator layer for injection of electrons, characterized in that said insulation layer has spaced apart therein at least two injection regions and wherein one of said injection regions is situated adjacent to the gate electrode and at least the second of which is situated adjacent to a floating gate or an electron trapping region, said injection regions comprising regions of increasing or constant excess silicon content.

7. The structure as claimed in claim 6, characterized in that the gate structure is composed of an oxide formed on a silicon substrate and having vertically disposed therein between its gate electrode and said silicon substrate regions of increasing or constant excess silicon concentrations.

8. The structure as claimed in claim 6, characterized in that the gate structure is composed of a silicon nitride layer formed on a silicon substrate and having disposed therein between its gate electrode and said Si substrate its regions of increasing or constant excess silicon concentrations.

9. The structure as claimed in claim 7, characterized in that said regions of increasing or constant excess silicon concentrations consists of Si rich $SiO_2$.

10. The structure as claimed in claim 7, characterized in that said regions of increasing or constant excess silicon concentrations consist of Si rich $Si_2N_4$.

11. A MOSFET device for performing a memory function, comprising a silicon substrate having source and drain regions formed therein and having disposed thereon an insulator and an insulated gate structure formed therein between said source and drain regions and a gate electrode on top of said insulator for injection of electrons, characterized in that said insulator of the insulated gate structure has vertically disposed near its opposing surface regions (1 and 3) of increasing or constant concentrations of Si to provide at least two regions wherein electrons can be injected from either of the opposing regions depending on a negative voltage bias of −10 to −30 volts or positive voltage of +10 to +30 volts applied to said gate electrode.

12. The device as claimed in claim 1, characterized in that said insulator comprises a thermal oxide having regions of increasing or constant excess Si concentrations therein, one of such regions being in the vicinity of the gate electrode interface and at least a second such region being in the vicinity of a floating gate or an electron trapping region.

13. The device as claimed in claim 12, characterized in that said insulator comprises a nitride layer having regions of increasing or constant excess Si concentrations, one of such regions being in the vicinity of the gate electrode interface and at least a second such region being in the vicinity of a floating gate or an electron trapping region.

14. The device as claimed in claim 12, characterized in that said insulator comprises an oxide layer having regions of $Si_3N_4$ with increasing or constant Si concentrations one of such regions being in the vicinity of the gate electrode interface and at least a second such region being in the vicinity of a floating gate or charge trapping layer.

**Revendications**

1. Structure métal-isolant-semiconducteur (MIS) comportant un substrat en silicium sur lequel est disposé une couche isolante, et des moyens de polarisation situés à la partie supérieure de ladite couche isolante pour l'injection d'électrons, caractérisée en ce que ladite couche isolante comporte, dans des positions espacées en son intérieur, au moins deux régions (1 et 3) riches en silicium, disposées verticalement l'une par rapport à l'autre et parmi lesquelles la région supérieure (1) riche en silicium provoque l'injection d'électrons lorsqu'une tension de polarisation négative de −10 à −30 volts est appliquée auxdits moyens de polarisation (2) et parmi lesquelles la région inférieure riche en silicium (3) provoque l'injection d'électrons lorsqu'une tension de polarisation positive de +10 à +30 volts est appliquée auxdits moyens de polarisation (2), ce qui a pour effet que l'on peut obtenir des nombres d'environ $10^5$ cycles d'enregistrement-effacement sans rupture de la structure, lesdits cycles d'effacement se produisant pendant des durées équivalentes à celles dudit cycle d'enregistrement.

2. Structure selon la revendication 1, caractérisée par un substrat en silicium sur lequel est disposée une couche isolante en dioxyde de silicium, sur laquelle est disposé un contact électrique (2), ladite couche isolante en dioxyde de silicium comportant en elle-même des régions (1 et 3) superposées verticalement et possédant des compositions graduelles ou échelonnées à proximité de leurs surfaces en vis-à-vis.

3. Structure selon la revendication 1, caractérisée en ce que ladite couche isolante est constituée par du dioxyde de silicium contenant une teneur croissante ou constante de silicium en excès.

4. Structure selon la revendication 1, caractérisée par un substrat en silicium sur lequel est disposée une couche isolante de nitrure de silicium, sur laquelle est placé un contact électrique, ladite couche de nitrure de silicium comportant au moins deux régions (1 et 3) riches en Si et superposées verticalement dans cette couche.

5. Structure selon la revendication 1, caractérisé en ce que ladite couche isolante est constituée par du nitrure de silicium contenant une teneur croissante ou constante de silicium en excès.

6. Structure (MGOS)FET métal-dioxyde de silicium-silicium dont l'oxyde possède une teneur graduelle, ou structure métal-dioxyde de silicium-silicium, dont l'oxyde possède une teneur échelonnée, comportant un substrat en silicium sur lequel sont disposées une couche isolante et un électrode de grille située à la partie supérieure de ladite couche isolante pour l'injection d'électrons, caractérisée en ce que ladite couche isolante comporte, en des positions réciproquement distantes en son intérieur, au moins deux régions d'injection, parmi lesquelles l'une desdites régions d'injection est située au voisinage de l'électrode de grille et au moins la seconde de ces régions est située au voisinage d'une grille flottante ou d'une région de piégeage d'électrons, lesdites régions d'injection comprenant des régions possédant une teneur croissante ou constante de silicium en excès.

7. Structure selon la revendication 6, caractérisée en ce que la structure de grille est constituée par un oxyde formé sur un substrat en silicium et contenant, entre son électrode de grille et ledit substrat en silicium, des régions superposées verticalement dans la structure et possédant des teneurs croissantes ou constantes de silicium en excès.

8. Structure selon la revendication 6, caractérisée en ce que la structure de grille est constituée par une couche de nitrure de silicium formée sur un substrat en silicium et contenant en son intérieur, entre son électrode de grille et ledit substrat en Si, des régions possédant des teneurs croissantes ou constantes de silicium en excès.

9. Structure selon la revendication 7, caractérisée en ce que lesdites régions possédant des teneurs croissantes ou constantes de silicium en excès sont constitués par du $SiO_2$ riche en Si.

10. Structure selon la revendication 7, caractérisée en ce que lesdites régions possédant des teneurs croissantes ou constantes de silicium en excès sont constituées par du $Si_3N_4$ riche en Si.

11. Dispositif MOSFET servant à réaliser une fonction de mémoire, comprenant un substrat en silicium possédant des régions de source et de drain formées en son intérieur et un isolant situé sur le substrat et une structure de grille isolée disposée en son intérieur entre lesdites régions de source et de drain, et une électrode de grille située à la partie supérieure dudit isolant pour l'injection d'électrons, caractérisé en ce que ledit isolant de la structure de grille isolée possède des régions (1 et 3) superposées verticalement à proximité des surfaces opposées dudit isolant et possédant des teneurs croissantes ou constantes en Si de manière à former au moins deux régions dans lesquelles des électrons peuvent être injectés à partir de l'une ou l'autre des régions opposées en fonction d'une tension de polarisation négative de $-10$ à $-30$ volts ou d'une tension de polarisation positive de $+10$ à $+30$ volts, appliquée à ladite électrode de grille.

12. Dispositif selon la revendication 1, caractérisé en ce que ledit isolant se compose d'un oxyde thermique contenant des régions possédant des teneurs croissantes ou constantes de silicium en excès, l'une de ces régions étant au voisinage de l'interface de l'électrode de grille et au moins une seconde de ces régions étant au voisinage d'une grille flottante ou d'une région de piégeage des électrons.

13. Dispositif selon la revendication 12, caractérisé en ce que ledit isolant contient une couche de nitrure comportant des régions possédant des teneurs croissantes ou constantes de silicium en excès, l'une de ces régions étant au voisinage de l'interface avec l'électrode de grille et au moins une seconde de ces régions étant au voisinage de la grille flottante ou d'une région de piégeage des électrons.

14. Dispositif suivant la revendication 12, caractérisé en ce que ledit isolant est constitué par une couche d'oxyde comportant des régions de $Si_3N_4$ possédant des teneurs croissantes ou constantes en Si, l'une de ces régions étant au voisinage de l'interface avec l'électrode de grille et au moins une seconde de ces régions étant au voisinage d'une grille flottante ou d'une couche de piégeage des charges.

**Patentansprüche**

1. Metall-Isolator-Halbleiter-(MIS-)Struktur, welche ein Siliziumsubstrat mit einer darauf angeordneten Isolatorschicht und Vorspannungsmittel aud der Isolatorschicht für die Injektion von Elektronen aufweist, dadurch gekennzeichnet, daß in der Isolatorschicht wenigstens zwei im Abstand liegende, relativ zueinander vertikal angeordnete siliziumreiche Bereiche (1 und 3) vorhanden sind, wobei der zu oberst angeordnete siliziumreiche Bereich (1) zu einer Elektroneninjektion veranlaßt wird, wenn eine negative Vorspannung von −10 bis −30 Volt an die Vorspannungsmittel (2) angelegt wird, und wobei der unterste siliziumreiche Bereich (3) Elektronen injiziert, wenn eine positive Vorspannung von +10 bis 30 Volt an die Vorspannungsmittel (2) angelegt wird, wodurch Schreib-Löschzyklen in einer Zahl von ungefähr $10^5$ ohne Strukturzusammenbruch erzielt werden können und wobei die Löschzyklen in den Schriebzyklen äquivalenten Zeiten auftreten.

2. Struktur nach Anspruch 1, gekennzeichnet durch ein Siliziumsubstrat mit einer darauf befindlichen Siliziumdioxid-Isolatorschicht und einen elektrischen Kontakt (2) auf der Siliziumdioxid-Isolatorschicht, wobei die Siliziumdioxid-Isolatorschicht vertikal darin angeordnet Bereiche (1 und 3) mit stetig oder gestuft sich ändernden Zusammensetzungen in der Nähe ihrer gegenüberstehenden Oberflächen aufweist.

3. Struktur nach Anspruch 1, dadurch gekennzeichnet, daß die Isolatorschicht aus Siliziumdioxid aufgebaut ist, welches, einen zunehmenden oder konstanten Siliziumüberschußgehalt enthält.

4. Struktur nach Anspruch 1, gekennzeichnet durch ein Siliziumsubstrat mit einer darauf befindlichen Siliziumnitrid-Isolatorschicht und einen elektrischen Kontakt auf der Siliziumnitrid-Schicht, wobei die Silizium-nitrid-Schicht vertikal darin angeordnet wenigstens 2 Si reiche Bereiche (1 und 3) aufweist.

5. Struktur nach Anspruch 1, dadurch gekennzeichnet, daß die Isolatorschicht aus Siliziumnitrid aufgebaut ist, welches einen zunehmenden oder konstanten Siliziumüberschußgehalt enthält.

6. Eine verlaufend sich ändernde Oxidkonzentration aufweisende Metall-Siliziumdioxid-Silizium-(MGOS-)FET-Struktur oder eine gestufte Oxidkonzentration aufweisende Metall-Siliziumdioxid-Siliziumstruktur, welche ein Siliziumsubstrat mit einer darauf angeordneten Isolatorschicht und eine Gate-Elektrode auf der Isolatorschicht für die Injektion von Elektronen aufweist, dadurch gekennzeichnet, daß die Isolatorschicht im Abstand darin liegend wenigstens zwei Injektionsbereiche aufweist, wobei einer der Injektionsbereiche angrenzend an die Gate-Elektrode liegt und wenigstens der zweite derselben angrenzend an ein Gate mit schwimmendem Potential oder einen Elektroneneinfangbereich liegt, wobei die Injektionsbereiche Bereiche eines zunehmenden oder eines konstanten Siliziumüberschußgehalts umfassen.

7. Struktur nach Anspruch 6, dadurch gekennzeichnet, daß die Gate-Struktur aus einem Oxid aufgebaut ist, welches auf einem Siliziumsubstrat ausgebildet ist und vertikal darin angeordnet zwischen ihrer Gate-Elektrode und dem Siliziumsubstrat Bereiche zunehmender oder konstanter Siliziumüberschußkonzentrationen aufweist.

8. Struktur nach Anspruch 6, dadurch gekennzeichnet, daß die Gate-Struktur aus einer Silizium-nitrid-Schicht aufgebaut ist, welche auf einem Siliziumsubstrat ausgebildet ist und darin angeordnet zwischen ihrer Gate-Elektrode und dem Si-Substrat ihre Bereiche zunehmender oder konstanter Siliziumüberschußkonzentrationen aufweist.

9. Struktur nach Anspruch 7, dadurch gekennzeichnet, daß die Bereiche zunehmender oder konstanter Siliziumüberschußkonzentrationen aus Si-reichem $SiO_2$ bestehen.

10. Struktur nach Anspruch 7, dadurch gekennzeichnet, daß die Bereiche zunehmender oder konstanter Siliziumüberschußkonzentrationen aus Si-reichem $Si_3N_4$ bestehen.

11. MOSFET-Vorrichtung zur Durchführung einer Speicherfunktion, welche ein Siliziumsubstrat mit darin ausgebildeten Source- und Drain-Bereichen und einem darauf angeordneten Isolator und eine zwischen den Source- und Drain-Bereichen darin ausgebildete Isoliertgate-Struktur und eine Gate-Elektrode auf dem Isolator für die Injektion von Elektronen aufweist, dadurch gekennzeichnet, daß der Isolator der Isolietgate-Struktur vertical angeordnet in der Nähe ihrer gegenüberliegenden Oberfläche Bereiche (1 und 3) zunehmender oder konstanter Si-Konzentrationen zur Schaffung von wenigstens zwei Bereichen aufweist, bei denen Elektronen von jedem der gegenüberleigenden Bereiche abhängig von einer an die Gate-Elektrode angelegten negativen Vorspannung von −10 bis −30 Volt oder positiven Spannung von +10 bis +30 Volt injiziert werden können.

12. Vorrichtung nach Anspruch 11, dadurch gekennzeichnet, daß der Isolator ein thermisches Oxid umfaßt, welches darin Bereiche zunehmender oder konstanter Si-Überschußkonzentrationen aufweist, wobei einer dieser Bereiche in der Nachbarschaft der Gate-Elektrodengrenzfläche und wenigstens ein zweiter solcher Bereich in der Nachbarschaft eines Gate mit schwimmendem Potential oder eines Elektroneneinfangsbereichs liegt.

13. Vorrichtung nach Anspruch 11, dadurch gekennzeichnet, daß der Isolator eine Nitridschicht umfaßt, welche Bereiche zunehmender oder konstanter Si-Überschußkonzentrationen aufweist, wobei einer dieser Bereiche in der Nachbarschaft der Gate-Elektrodengrenzfläche und wenigstens ein zweiter solcher Bereich in der Nachbarschaft eines Gate mit schwimmendem Potential oder eines Elektroneneinfangbereichs liegt.

14. Vorrichtung nach Anspruch 11, dadurch gekennzeichnet, daß der Isolator eine Oxidschicht umfaßt, welche Bereiche aus $Si_3N_4$ mit

zunehmenden oder konstanten Si-Konzentrationen aufweist, wobei einer dieser Bereiche in der Nachbarschaft der Gate-Elektrodengrenzfläche und wenigstens ein zweiter solcher Bereich in der Nachbarschaft eines Gate mit schwimmendem Potential oder einer Ladungseinfangschicht liegt.

**0 034 653**

## FIG. 1

SOURCE      GATE      DRAIN

$V_S$      $V_g$      $V_D$

$e^-$ INJECTOR FOR $V_g^-$

$SiO_2$

$SiO_2$

POLY Si

$SiO_2$    $e^-$ INJECTOR FOR $V_g^+$

$n^+$      $n^+$

$p^-$ Si

1

# FIG. 2

## FIG. 3

# FIG. 4